(19) Europäisches Patentamt
European Patent Office
Office européen des brevets

(11) **EP 2 192 825 A1**

(12) **EUROPEAN PATENT APPLICATION**

(43) Date of publication:
**02.06.2010 Bulletin 2010/22**

(51) Int Cl.:
*H05K 3/28* *(2006.01)* *H01L 21/56* *(2006.01)*
*B29C 45/14* *(2006.01)*

(21) Application number: **08170026.2**

(22) Date of filing: **26.11.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicants:
• **Osram Gesellschaft mit beschränkter Haftung**
  **81543 München (DE)**
• **Osram S.p.A. - Societa' Riunite Osram Edison Clerici**
  **20144 Milano (IT)**
  Designated Contracting States:
  **IT**

(72) Inventors:
• **Toscan, Matteo**
  **31010 Maser (Treviso) (IT)**
• **Grosso, Davide**
  **31100 Treviso (IT)**

(74) Representative: **Bosotti, Luciano**
  **Buzzi, Notaro & Antonielli d'Oulx**
  **Via Maria Vittoria, 18**
  **10123 Torino (IT)**

(54) **An injection tool for encapsulating electronic circuits with light sources, and related encapsulation process**

(57)    An injection tool (1) for encapsulating an electronic circuit including a printed circuit board (2) and at least one light source (L) arranged thereon. The injection tool (1) comprises support (14) and protection (10) structures for supporting the electronic circuit within the injection tool (1) and for protecting the light emitting surface of at least one light source (L) from encapsulation material (M), respectively. At least one of the support (14) and protection (10) structures is mobile for compensating for dimensional tolerances in the electronic circuit.

*Fig. 2*

**Description**

Field of the invention

This disclosure relates to techniques for encapsulating electronic circuits.
More specifically, this disclosure was devised with specific attention paid to its possible use in a low pressure hot melt moulding process of an electronic circuit comprising at least one Light Emitting Diode (LED) module.

Description of the related art

LED modules are increasingly used for lighting applications, such as for home environments. Such LED modules are usually mounted together with other electronic components, such as a driver circuit and wires, on a Printed Circuit Board (PCB). An encapsulation process may be used in order to improve the reliability and mechanical stability of the circuit.
For example, a low pressure hot melt moulding process may be used to seal the electronic components mounted on the PCB with a polyamide material.

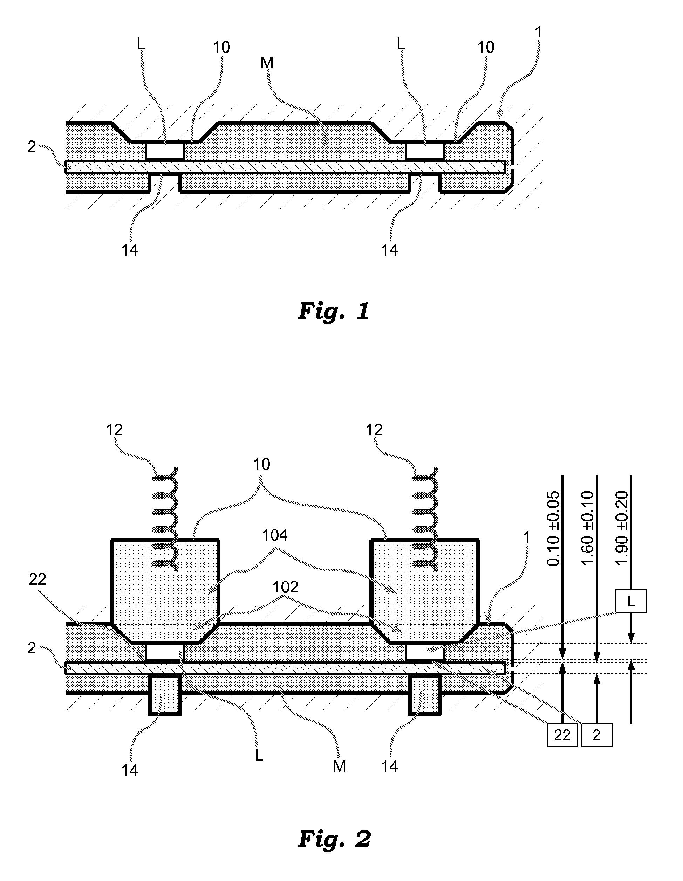

Figure 1 is exemplary of such an encapsulation process. In such a process, a PCB 2 having mounted thereon at least one LED device L (two such components are shown in Figure 1) is arranged in a tool 1. The PCB is retained in the tool 1 by means of a support structure 14. Subsequently, a melted polyamide material M is injected into the tool 1 in order to "seal", i.e. cover the PCB 2. The tool 1 usually comprises also one or more protection elements 10 for protecting the light emitting surface of the LED device L.

Object and summary of the invention

Due to dimensional tolerances of the components (e.g. the LED device height or PCB thickness) and process variables (e.g. solder paste quantity and thickness), the total distance between the bottom side of the PCB (which is in contact with the fixed support 14) and the top side of the LED device (which is protected by means of the protection elements 10) may vary. Such protections 10 and supports 14 being fixed imply a high risk of damaging the LED device (s) or to leave between the surface of the LED device(s) L and the protection 10 an empty space where encapsulation material M may penetrate and thus cover the light emitting surface of the LED device.
The object of the invention is to provide techniques for encapsulating an electronic circuit, which overcome the drawbacks mentioned in the foregoing.
According to the present invention, that object is achieved by means of an injection tool for encapsulating an electronic circuit having the features set forth in the claims that follows. The invention also relates to a corresponding process for encapsulating an electronic circuit.
The claims form an integral part of the disclosure of the invention as provided herein.
In an embodiment, the arrangement as described herein is an injection tool for encapsulating an electronic circuit comprising at least one light source, such as a LED device.
In an embodiment, this tool is used in a low pressure hot melt moulding encapsulating process.
In an embodiment, polyamide material, such as Macromel OM641 by Henkel, is melted in a pot at a temperature of approximately 220°C and then injected into the tool in order to seal and to cover all the conductive parts. Thus the electronic circuit may be insulated and protected from water condensation and corresponding corrosion.
In an embodiment, the tool is a stainless steel tool, such as an 8 cavities stainless steel tool.
In an embodiment, an active protection system is used for the light source.
In an embodiment, the protection and/or the support structure of the tool are mobile in order perfectly close the form on the electronic circuit, while avoiding any damages to the LED module.
In an embodiment, the protection and/or the support structures of the tool have associated at least one flexible spring.
In an embodiment, which may be useful for electronic circuits comprising a plurality of LED devices, the protection is mobile and the support is fixed. In fact, the inventors have recognized that exclusively mobile supports may have limitations when being applied to electronic circuits comprising more than 3 LED devices, because each lighting point may have a different height as a result of dimensional and process variables.
Thus the arrangement described herein provides encapsulation techniques suitable for compensating dimensional tolerances and process variables. In this way, high reliability and mechanic stability of the electronic circuit may be guaranteed, while ensuring that the light emitting surface of the LED device(s) is left uncovered.

Brief description of the annexed representations

The invention will now be described, by way of example only, with reference to the annexed representations, wherein:

- figure 1 has been described in the foregoing;
- figure 2 is exemplary of one way of implementing an embodiment of the arrangement described herein; and
- figures 3 to 5 are illustrative of the advantages the arrangement described herein.

Detailed description of exemplary embodiments

In the following description, numerous specific details are given to provide a thorough understanding of embodiments. The embodiments can be practiced without one or more of the specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

Figure 2 shows an embodiment of an injection tool 1 as already discussed in the foregoing, including one mobile protection system 10 for each LED L as well as fixed supports 14.

As used herein, "mobile" denotes the possibility for the protection system (or at least the "distal" end thereof, facing the LED) to displace itself in order to allow for tolerances in manufacturing and/or positioning the LED and the PCB. Such an injection tool may compensate both components' dimension tolerances and process tolerances.

In the exemplary embodiment shown herein, the protection system 10 and the supports 14 are arranged to operate on opposite sides with respect to the electronic circuit.

In the exemplary embodiment shown herein, each protection system 10 is elastically biased (i.e. spring-loaded) against the LED L via an associated helical spring 12, which urges the protection system against the device.

In an embodiment, the force of the spring 12 may be adjusted, e.g. by means of an adjustable screw (not shown).

For example, in a typical embodiment, a force in the range between 0 and 10kg may be set. In that way, it is possible to adjust the protection system independently for each device. Thus, it is even possible to reuse the same injection tool for electronic circuits comprising devices having different nominal heights.

After the electronic circuit has been inserted into the tool, the polyamide material M is injected.

In an embodiment, the encapsulation process comprises three phases:

1) injection of the melted material into the form in order to fill the cavities;
2) compensation in order to wait for a compensation of the shrinking effect of the injected material; and
3) cooling in order to decrease the temperature of the injected material.

In an embodiment, the tank which contains the melted material is kept at approximately 200°C, the injection heads have a temperature of approximately 215°C and the tube between them has a temperature of approximately 210°C. In an embodiment, injection occurs with a pressure of 20 to 25 bar.

In the exemplary embodiment shown herein, the protection structure 10 comprises a tapered (e.g. frustum-like) portion 102 extending distally of a body portion 104 which is subjected to the action of the spring 12 in order to urge the portion 102 against the LED module L.

In an embodiment, the width of the portion 102 is selected sufficient large in order to avoid any significant influence of the encapsulation material on the light emission of the LED device L.

In the exemplary embodiment shown with respect to figure 2, the frustum-like portion 102 has a height, which is equal to the height of the molded PCB minus the maximum height the top surface of the LED device L may reach.

As already indicated, the term "mobile" is used herein to denote the possibility for the protection system 10 or at least the distal end thereof, facing the LED (e.g. the frustum-like portion 102) to displace itself in order to allow for tolerances in manufacturing and/or positioning the LED and the PCB. It will be appreciated that such mobility may be achieved by other means than those illustrated herein by way of example only: for instance, the mobility of a frustum-like portion as shown at 102 could be achieved by rendering the system 10 elastically compressible as a whole.

Figure 2 shows in that respect exemplary tolerance values for a PCB 2 having mounted thereon a LED device L by means of solder paste 22.

Typical component tolerances may include the height of the LED device L (e.g. 1.90 ±0.20 mm) and the thickness of the PCB 2 (e.g. 1.60 ±0.10 mm), and typical process tolerances may include the thickness of the solder paste layer 22 (e.g. 0.10 ±0.05 mm) or components' positions.

The maximum height $H_M$ is the total sum of the components' nominal thickness and the sum of the maximum tolerances $V_i$:

$$H_M \; = \; T_n \; + \; \Sigma \; V_i \; = \; T_n \; + \; P_M \; + \; SP_M \; + \; L_M$$

wherein $H_M$ is the maximum height of the product including PCB 2, solder paste 22 and LED device L, $T_n$ is the nominal height of the product including PCB 2, solder paste 22 and LED device L, $P_M$ is the maximum positive tolerance for the height of the PCB 2, $SP_M$ is the maximum positive tolerance of the thickness of the solder paste, and $L_M$ is the maximum positive tolerance of the height of the LED package.

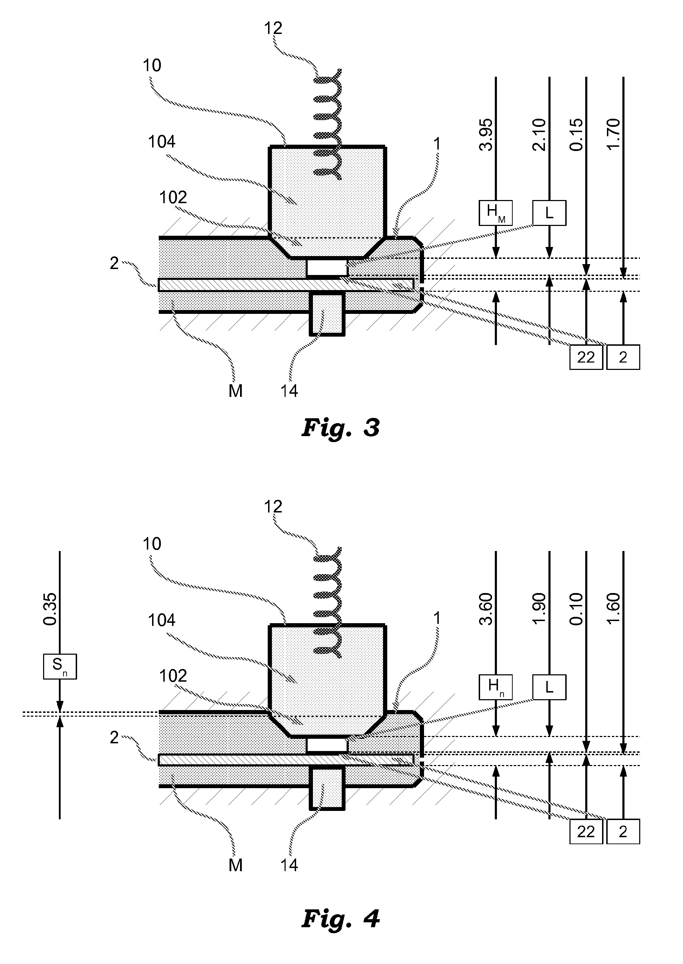

Figure 3 shows the case where the product has the maximum height $H_M$, which means that the frustum-like portion 102 arrives exactly at the height of the molded electronic circuit, denominated in the following "zero level". Specifically, for the exemplary nominal and tolerance values, the PCB 2 would have a thickness of 1.70 mm, the LED device L would have a height of 2.10 mm, and the solder paste would have a thickness of 0.15 mm, thus providing a maximum product's height $H_M$ of 3.95 mm.

Conversely, when the components and materials have a height which is less than the maximum $H_M$, the frustum-like portion 102 immerges into the molded material M, and a visible step $S$ is created, which does not exist for the "zero level" case.

For example, figure 4 shows the situation where all components have their nominal height or thickness, thus creating a step having the height $S_n$:

$$S_n \; = \; \Sigma \; V_i \; = \; P_M \; + \; SP_M \; + \; L_M$$

Specifically, for the exemplary nominal and tolerance values, the PCB 2 would have a thickness of 1.60 mm, the LED device L would have a height of 1.90 mm, and the solder paste would have a thickness of 0.10 mm, thus providing a nominal product's height $H_n$ of 3.60 mm and a step height $S_n$ of 0.35 mm.

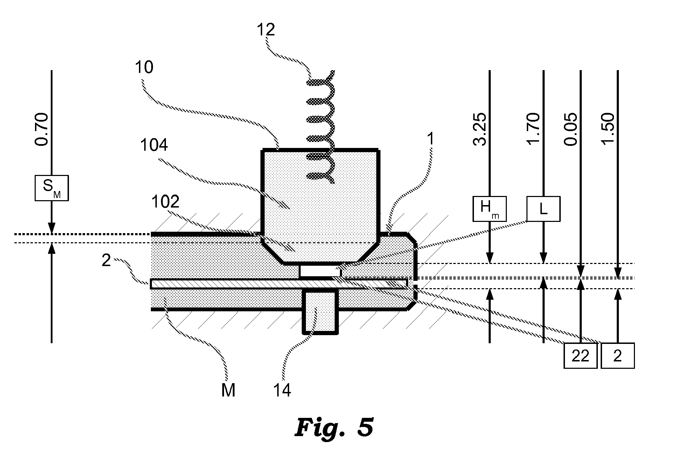

Figure 5, shows the situation where all components have their minimum height or thickness, thus creating the maximum step height $S_M$:

$$S_M \; = \; 2 \; \cdot \; S_n \; = \; 2 \; \cdot \; (P_M \; + \; SP_M \; + \; L_M)$$

Specifically, for the exemplary nominal and tolerance values, the PCB 2 would have a thickness of 1.50 mm, the LED device L would have a height of 1.70 mm, and the solder paste would have a thickness of 0.50 mm, thus providing a minimum product's height $H_m$ of 3.25 mm and a maximum step height $S_M$ of 0.70 mm.

In an embodiment, the "mobile" protection 10 may be used together with a flexible (i.e. again "mobile") support structure 14, which further facilitates compensation of possible unevenness in the PCB 2.

In an embodiment, a "mobile" support structure 14 may be used in connection with one or more "fixed" protections 10. This embodiment may not create a variable step through the immersion of the portion 102 in the melted material; this embodiment may be useful for electronic circuits comprising less than three LED devices.

The above described arrangement of a mobile protection and/or support structure for an injection tools has several advantages. For example, the optical characteristics of the LED module are maintained, and the reliability and mechanical robustness is increased.

The arrangement adapts itself to dimensional tolerances in the components, such as PCB and driver components and LED device. The arrangement adapts itself also to dimensional tolerances resulting from process variables, such as solder paste deposition and reflow process.

Several of the embodiments described are able to adapt the tool for each individual light point.

Preferably, an adjustable elastic force is used for each light point, thus allowing to adapt the tool to the specific application requirements.

Those of skill in the art will appreciate that the arrangements described herein may be applied to any number of LED devices and to any type of injection tools.

Without prejudice to the underlying principles of the invention, the details and embodiments may vary, even significantly, with respect to what has been described herein merely by way of example, without departing from the scope of the invention as defined by the annexed claim.

**Claims**

1. An injection tool (1) for encapsulating an electronic circuit including a printed circuit board (2) and at least one light source (L) arranged thereon, wherein said injection tool (1) comprises support (14) and protection (10) structures for supporting said electronic circuit within said injection tool (1) and for protecting the light emitting surface of at least one light source (L) from encapsulation material (M), respectively, wherein at least one of said support (14) and protection (10) structures is mobile for compensating for dimensional tolerances in said electronic circuit.

2. The injection tool (1) of Claim 1, wherein said support (14) and protection (10) structures are arranged to operate on opposite sides with respect to said electronic circuit.

3. The injection tool (1) of either of Claims 1 or 2, wherein at least one of said support (14) and protection (10) structures is elastically urged (12) against said electronic circuit.

4. The injection tool (1) of Claim 3, wherein said at least one of said support (14) and protection (10) structures is spring-biased (12) against said electronic circuit.

5. The injection tool (1) of Claim 4, including an adjustable spring (12) to adjust the intensity of the spring bias applied to said at least one of said support (14) and protection (10) structures.

6. The injection tool (1) of any of the previous claims including at least one protection structure (10) for protecting the light emitting surface of at least one light source (L), wherein said at least one protection structure (10) includes a tapered portion (102) to face said light emitting surface.

7. The injection tool (1) of Claim 6, wherein said tapered portion (102) is frustum-shaped.

8. The injection tool (1) of any of the previous claims, wherein said support (14) and protection (10) structures are fixed and mobile, respectively.

9. The injection tool (1) of any of Claims 1 to 7, wherein both of said support (14) and protection (10) structures are mobile.

10. The injection tool (1) of any of the Claims 1 to 7, wherein said support (14) and protection (10) structures are mobile and fixed, respectively.

11. The injection tool (1) of any of the previous claims, including a plurality of said support structures (14).

12. The injection tool (1) of any of the previous claims, including a plurality of said protection structures (10).

13. A process for encapsulating an electronic circuit including a printed circuit board (2) and at least one light source (L) arranged thereon, the process including the steps of:

- providing an injection tool (1) according to any of claims 1 to 12,
- arranging said electronic circuit in said injection tool (1), whereby said support (14) and protection (10) structures support said electronic circuit within said injection tool (1) and protect the light emitting surface of at least one light source (L) from encapsulation material (M), respectively, and
- injecting an encapsulation material (M) into said injection tools (1), whereby said encapsulation material is prevented from reaching said light emitting surface of said at least one respective light source (L).

14. The process of Claim 13, wherein said encapsulation material (M) is injected into said injection tool (1) by means of a low pressure hot melt moulding process.

15. The process of either of Claims 13 or 14, including selecting a light emitting diode device as said at least one light source (L).

**Fig. 1**

**Fig. 2**

**Fig. 3**

**Fig. 4**

EP 2 192 825 A1

Fig. 5

8

Europäisches
Patentamt

European
Patent Office

Office européen
des brevets

## EUROPEAN SEARCH REPORT

**Application Number**

EP 08 17 0026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2003/214021 A1 (ZHOU TIAO [US] ET AL) 20 November 2003 (2003-11-20) * the whole document * ----- | 1-15 | INV. H05K3/28 H01L21/56 |
| Y | US 2004/017000 A1 (CHIU ANTHONY M [US] ET AL) 29 January 2004 (2004-01-29) * abstract * * paragraphs [0032] - [0037] * ----- | 1-15 | ADD. B29C45/14 |
| Y | US 2006/014328 A1 (SHIMONAKA TOMOYA [JP] ET AL SHIMONAKA TOMOYA [JP] ET AL) 19 January 2006 (2006-01-19) * abstract * * paragraphs [0034] - [0057] * * figures 4-9 * ----- | 1-3,6-15 | |
| Y | JP 2004 119410 A (TOWA CORP) 15 April 2004 (2004-04-15) * abstract * * figure 2 * ----- | 1-3,8-15 | |

**TECHNICAL FIELDS SEARCHED (IPC)**

B29C
H05K
H01L

The present search report has been drawn up for all claims

| Place of search | Date of completion of the search | Examiner |
|---|---|---|
| The Hague | 27 April 2009 | Deconinck, Eric |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 17 0026

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2009

| Patent document cited in search report | | Publication date | Patent family member(s) | | Publication date |
|---|---|---|---|---|---|
| US 2003214021 | A1 | 20-11-2003 | US 2007085222 | A1 | 19-04-2007 |
| US 2004017000 | A1 | 29-01-2004 | US 2004017002 | A1 | 29-01-2004 |
| US 2006014328 | A1 | 19-01-2006 | JP 2006027082 | A | 02-02-2006 |
| | | | SG 119319 | A1 | 28-02-2006 |
| | | | TW 279867 | B | 21-04-2007 |
| | | | US 2008213947 | A1 | 04-09-2008 |
| JP 2004119410 | A | 15-04-2004 | JP 4017480 | B2 | 05-12-2007 |